**Europäisches Patentamt**

(19) **European Patent Office**

**Office européen des brevets**

(11) Veröffentlichungsnummer: **0 009 085**
**B1**

(12) **EUROPÄISCHE PATENTSCHRIFT**

(45) Veröffentlichungstag der Patentschrift: **26.01.83**

(21) Anmeldenummer: **79102454.0**

(22) Anmeldetag: **16.07.79**

(51) Int. Cl.³: **H 03 K 3/353,**
**G 11 C 11/24**

(54) Verriegelungsschaltung zur Phasenaufspaltung und Pegelumsetzung eines TTL-Eingangssignals mit Feldeffekttransistoren und entsprechendes Betriebsverfahren.

(30) Priorität: **06.09.78 DE 2838817**

(43) Veröffentlichungstag der Anmeldung:
**02.04.80 Patentblatt 80/7**

(45) Bekanntmachung des Hinweises auf die Patenterteilung:
**26.01.83 Patentblatt 83/4**

(84) Benannte Vertragsstaaten:
**AT DE FR GB NL SE**

(56) Entgegenhaltungen:
DE - A - 2 420 663
US - A - 4 038 567

IBM TECHNICAL DISCLOSURE BULLETIN,
BAND 20, NR. 5, OKTOBER 1977, SEITEN
1714, 1715
NEW YORK, U.S.A.
K. S. GRAY: "BIT LINE RESTORE
SHORTING TECHNIQUE"

IBM TECHNICAL DISCLOSURE BULLETIN, Band
20, Nr. 1, Juni 1977, Seiten 268, 269
New York, U.S.A.
B. M. CASSIDY et al.: "Small Change Sense
Latch"

IBM TECHNICAL DISCLOSURE BULLETIN, Band
21, Nr. 2, Juli 1978, Seiten 882, 883

(73) Patentinhaber: **International Business Machines Corporation**
**Armonk, N.Y. 10504 (US)**

(72) Erfinder: **Gschwendtner, Jörg**
**Seitenstrasse 38**
**D-7300 Esslingen (DE)**
Erfinder: **Haug, Werner**
**Pontoiser Strasse 43**
**D-7300 Böblingen (DE)**
Erfinder: **Clemen, Rainer**
**Maurener Weg 133**
**D-7030 Böblingen (DE)**

(74) Vertreter: **Neuland, Johannes, Dipl.-Ing.**
**Schönaicher Strasse 220**
**D-7030 Böblingen (DE)**

(56) Entgegenhaltungen:
New York, U.S.A.
S. E. SCHUSTER: "High Performance Sense
Amplifier Circuit"

IBM TECHNICAL DISCLOSURE BULLETIN, Band
21, Nr. 3, August 1978, Seiten 1262, 1263
New York, U.S.A.
L. M. TERMAN et al.: "High Sensitivity
Charge Comparator For Sensing And Comparing
Very Small Charge Packets"

## Verriegelungsschaltung zur Phasenaufspaltung und Pegelumsetzung eines TTL-Eingangssignals mit Feldeffekttransistoren und entsprechendes Betriebsverfahren

Die in heutigen Datenverarbeitungsanlagen eingesetzten integrierten Halbleiterspeicher sind überwiegend in MOSFET-Technologie aufgebaut. Wegen ihrer höheren Schaltgeschwindigkeit werden im Rahmen einer solchen Datenverarbeitungsanlage jedoch auch an zahlreichen Stellen in bipolartechnologie aufgebaute integrierte Schaltkreise eingesetzt, z. B. für schnelle Register, Logik usw. Selbstverständlich muß für die einwandfreie Funktion eines derart aus Bipolar- und Feldeffektbausteinen zusammengesetzten komplexen Schaltungsnetzes die Einhaltung der jeweils erforderlichen Betriebs- und insbesondere Ansteuerspannungspegel gewährleistet sein. Da die genannten FET-Speicherbausteine in typischen Fällen ihre Ansteuersignale von den Ausgängen von Bipolarbausteinen zugeführt bekommen, stellt sich an diesen Nahtstellen stets das Problem der zugehörigen Pegelanpassung.

Ein für Schaltkreiskonzepte mit Bipolartransistoren typisches Spannungspegelschema ist das sog. TTL-Pegelschema. Dabei ist beispielsweise vereinbart, daß der eine Binärzustand, z. B. die logische "Null", durch eine Spannungswert im Bereich von 0 bis 0,6 V und entsprechend der andere Binärzustand, z. B. die logische "Eins", durch einen Spannungswert im Bereich von 2,4 bis zur Betriebsspannung von z. B. 5 V repräsentiert wird. Demgegenüber liegen die für MOSFET-Schaltkreise typischen Ansteuer- und Betriebsspannungswerte deutlich höher. Daraus folgt aber, daß ein mit einem im ungünstigsten Fall lediglich 2,4 V betragenden Eingangssignal für den oberen Binärzustand angesteuerter MOS-Feldeffekttransistor mit einem typischen Schwellenspannungswert $V_T$ von etwa 1,5 V nur relative schwach leiten würde. Mit anderen Worten, ein so angesteuerter Feldeffekttransistor würde auch in seinem Leitzustand noch relativ hochohmig sein und die von ihm verlangte Entladung eines weiteren Schaltungsknotens, einer Kapazität oder dergleichen nur vergleichsweise langsam durchführen können. Aus diesem Grunde wurden anfänglich an den Nahtstellen zwischen Bipolar- und FET-Bausteinen separate Pegelumsetzer-Bausteine in Bipolartechnologie vorgesehen, die hinsichtlich ihrer Ausgangsspannungen speziell auf die Eingangserfordernisse der FET-Bausteine zugeschnitten waren. Im Zuge der weiteren Entwicklung hat sich aber mehr und mehr die Forderung durchgesetzt, daß die FET-Speicherbausteine an ihren äußeren Anschlüssen voll TTL-kompatibel sind, so daß beim Entwurf des Gesamtsystems derartige Pegelnahtstellen im Verlauf der Signalführung, z. B. der Adreß- und Datenkanäle, nicht mehr gesondert berücksichtigt werden müssen.

Zusätzlich zu der Konvertierung der TTL-Signale auf die intern benötigten FET-Spannungen bzw. Spannungshübe müssen die Eingangsschaltkreise derartiger FET-Speicherbausteine die Daten- und Adreßsignale an den Eingängen meistens noch in zueinander gegenphasige Signale aufspalten. Dies hat seinen Grund darin, daß die Ansteuerung der Decodier- oder Datentreiberschaltkreise das jeweilige Signal im allgemeinen in der "wahren" und in der "komplementären" Form erfordert, und diese Phasenaufspaltung aufgrund der begrenzten Zahl zur Verfügung stehender Eingangsanschlüsse jeweils in dem betreffenden Baustein vorgenommen wird.

Die vorliegende Erfindung liegt auf dem Gebiet derartiger TTL-kompatibler Eingangsschaltungen, die in MOSFET-Technologie herstellbar sind und die beschriebene Pegelumsetzung sowie Phasenaufspaltung der Eingangssignale leisten. Bekannte Schaltungen dieser Art sind beispielsweise unter dem Titel "Address Buffer True/Complement Generator" von A. Furman im IBM Technical Disclosure Bulletin, Vol. 18; No. 11, vom April 1976 auf den Seiten 3597/3598 sowie unter dem Titel "True and Complement High Level Signal Circuit" von G. H. Parikh, ebenfalls erschienen im IBM Technical Disclosure Bulletin, Vol. 20, No. 3, vom August 1977 auf den Seiten 954 bis 956 beschrieben. Bei beiden Schaltkreisen werden zur Phasenaufspaltung der Adreß- bzw. Datensignale FET-Inverterstufen und zur Erreichung der gewünschten hohen FET-Spannungspegel sog. Bootstrap-Treiberstufen eingesetzt. Die derart erzeugten gegenphasigen Signalzustände werden dabei in einer ausgangsseitigen Verriegelungsschaltung fixiert. Auch aus der US Patentschrift 4 038 567 ist eine Schaltung zur Pegelumsetzung und Phasenaufspaltung bekannt. Bei ihr wird, ebenso wie bei der Schaltung, die unter dem Titel "Bipolar Logic Level to FET Logic Level Buffer Circuit" von S. C. Lewis u.a. im IBM Technical Disclosure Bulletin, Vol. 19, No. 8 vom Januar 1977 auf den Seiten 2953/2954 veröffentlicht wurde, das Eingangssignal direkt einem eingangsseitig vorgesehenen taktgesteuerten Verriegelungskreis (Flipflop) zugeführt. Dessen über Isolationselemente mit Ausgangstreiberstufen gekoppelte Kreuzkopplungsknoten werden in der Ruhephase aus der Betriebsspannungsquelle aufgeladen. Trotz der bei den beiden zuletzt genannten Schaltungen durch Ausnutzen der Verriegelungswirkung verbesserten Schaltgeschwindigkeit sind diese Schaltungen für besonders hohe Geschwindigkeitsanforderungen sowie wegen der zusätzlich erforderlichen Hilfs- und Referenzspannungen noch nicht vollauf befriedigend.

Die Erfindung, wie sie in den Patentansprüchen gekennzeichnet ist, löst die Aufgabe, eine demgegenüber hinsichtlich der Schaltgeschwindigkeit verbesserte Schaltung der genannten Art bereitzustellen, die mit möglichst wenig Steuersignalen und Hilfsspannungen auskommt. Gegenstand der Erfindung ist weiterhin ein entsprechendes Verfahren zur Bildung der genannten Signale. Zusammengefaßt sieht die Erfindung vor, daß über einen besonders ausgebildeten Ansteuerzweig das TTL-Eingangssignal an den zuvor möglichst hoch und gleich aufgeladenen Eingangsknoten eines taktgesteuerten Verriegelungsschaltkreises lediglich eine relativ kleine Spannungsdifferenz erzeugt, die dann beim Setzen der Verriegelungskreises durch die hoch vorgespannten und daher gut leitenden Feldeffekttransistoren des Verriegelungsschaltkreises schnell auf den vollen FET-Spannungshub verstärkt wird. Die entsprechend den unterschiedlichen Binärzuständen des TTL-Signals entgegengesetzten Zustände des Verriegelungsschaltkreises werden bei der vorliegenden einseitigen Ansteuerung durch eine definierte Entladung bzw. Potentialanhebung des betreffenden Eingangsknotens "eingeschrieben" und anschließend verriegelt. In einer vorteilhaften Weiterbildung läßt sich überdies erreichen, daß das angelegte Eingangssignal nur über einen relativ kleinen Zeitraum unverändert aufrechterhalten werden muß und sich bereits vor Ende der endgültigen Selektion wieder ändern kann.

Die Erfindung wird im folgenden anhand der lediglich einen Ausführungsweg darstellenden Zeichnungen näher erläutert. Es zeigen:

Fig. 1 das elektrische Schaltbild eines Ausführungsbeispiels der Erfindung und

Fig. 2 ein zugehöriges Impulsdiagramm zur Erläuterung der Arbeitsweise der Schaltung nach Fig. 1.

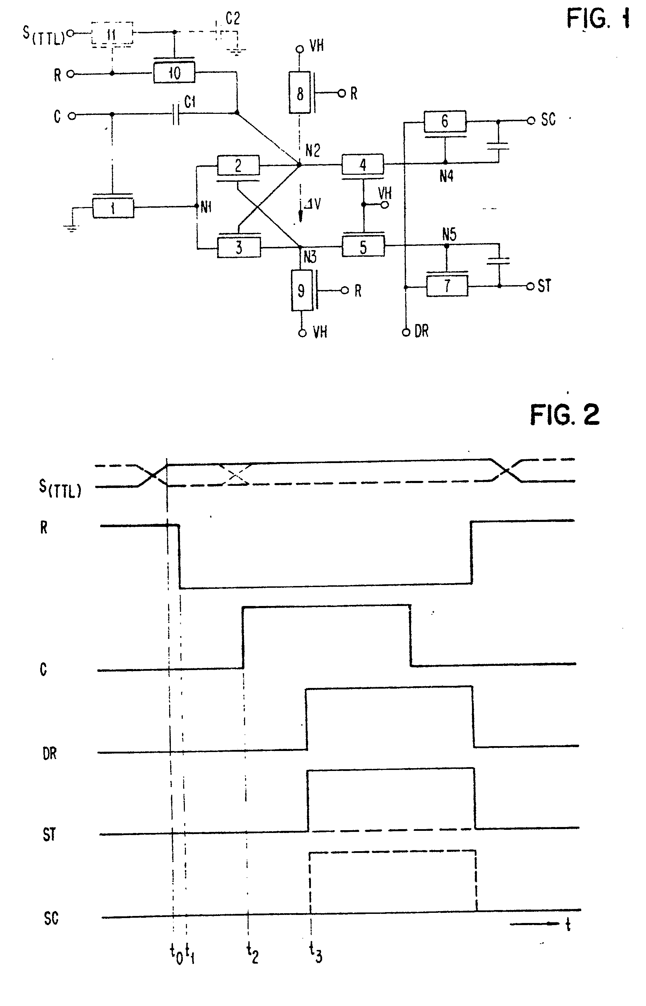

Bei dem in Fig. 1 dargestellten Ausführungsbeispiel der Erfindung sind übliche N-Kanal MOS-Feldeffekttransistoren vorausgesetzt, deren Betriebsspannung VH in typischen Fällen etwa +8,5 V beträgt. Die Erfindung kann jedoch in gleicher Weise auch mit Feldeffekttransistoren des anderen Leitungstyps und einer entsprechend geänderten Betriebsspannung realisiert werden. Weiterhin ist anzumerken, daß die in Fig. 2 angegebenen Impulsverläufe lediglich qualitativer Art sind.

In Fig. 1 ist mit S das TTL-Eingangssignal bezeichnet, das spannungsmäßig in FET-Pegel (Masse, VH) umgesetzt und aus dem das zugehörige wahre Ausgangssignal ST sowie das zugehörige komplementäre Ausgangssignal SC erzeugt werden soll. Bei diesem TTL-Eingangssignal S handelt es sich beispielsweise um ein Adreßsignal, das in die Decodierung einer bestimmten Speicherzelle auf dem Speicherbaustein eingeht. Für die übrigen noch angegebenen Steuerimpulse R, C und DR ist im Rahmen der vorliegenden Erfindung vorausgesetzt, daß sie bereits in vollen FET-Pegeln vorliegen. Diese Steuerimpulse werden üblicherweise ebenfalls intern aus einem einzigen extern zugeführten Baustein-Auswahlsignal mit TTL-Pegeln erzeugt. Der Steuerimpuls R bestimmt im wesentlichen den Ruhezustand, in dem die Schaltung auf definierte Anfangsverhältnisse eingestellt wird. Der Steuerimpuls C aktiviert die Schaltkreisfunktionen auf dem jeweiligen Baustein und besorgt beispielsweise im vorliegenden Fall das Setzen des Adreßverriegelungsschaltkreises. Der Steuerimpuls DR schließlich sei der Steuerimpuls für die Aktivierung der Ausgangstreiberstufen. Die Erzeugung der Steuerimpulse R, C und DR aus einem extern zugeführten Signal mit TTL-Pegeln kann in konventioneller Weise erfolgen. Festzuhalten ist, daß in die resultierende Zugriffszeit für eine Speicherzelle auf dem jeweiligen Baustein die für die Pegelumsetzung und Phasenaufspaltung des Eingangssignals S erforderliche Zeit akkumulierend eingeht. Gelingt es daher, die Signale ST/SC in kürzerer Zeit aus dem Eingangssignal $S_{(TTL)}$ zu erzeugen, geht damit unmittelbar eine entsprechende Verringerung der Zugriffszeit einher, was ständig angestrebt wird.

Für die nähere Erläuterung der Schaltung nach Fig. 1 kann der grundsätzliche Aufbau einer solchen Adreßverriegelungsschaltung als konventionell vorausgesetzt werden. Die Transistoren 1, 2 und 3 bilden ein sog. taktgesteuertes Flipflop, dessen Kreuzkopplungsknoten N2 und N3 über die Isolationstransistoren 4 und 5 jeweils mit einer ebenfalls an sich bekannten Bootstrap-Ausgangstreiberstufe mit den Transistoren 6 bzw. 7 gekoppelt sind. Von besonderer Bedeutung im Rahmen der vorliegenden Erfindung ist die Schaltungsausführung der einseitigen Ansteuerung des Schaltungsknotens N2 sowie der Aufladung der beiden Schaltungsknoten N2 und N3 im Ruhezustand über die Transistoren 8 und 9.

Für die Erläuterung des grundsätzlichen Schaltungsaufbaus der Ansteuerung des Verriegelungsschaltkreises seien zunächst einmal der Transistor 11 sowie der Kondensator C2 weggelassen. Auf diese Bauelemente wird später im Rahmen der Beschreibung einer vorteilhaften Weiterbildung der Erfindung näher eingegangen, weshalb diese Bauelemente in Fig. 1 lediglich in unterbrochenen Linien dargestellt sind. Der Schaltungsknoten N2 ist somit einmal über die Source-Drain-Strecke des Feldeffekttransistors 10 mit dem Eingang für den Steuerimpuls R verbunden. Am Gate des Transistors 10 liegt das TTL-Eingangssignal S. Auf den gleichen Schaltungsknoten N2 führt weiterhin eine kapazitive Kopplung über C1 vom Eingang für den Steuerimpuls C.

Zur weiteren Erläuterung der Schaltung von Fig. 1 und deren Wirkungsweise wird zusätzlich auf Fig. 2 Bezug genommen. In der Ruhephase, d.h. wenn der Steuerimpuls R seinen oberen Pegelzustand aufweist, werden die Knoten N2, N3, N4 und N5 mit Hilfe der Feldeffekttransistoren 8 und 9 aus der Betriebsspannungsquelle VH auf das Potential VH-VT und der Knoten N1 auf den Wert VH-2VT aufgeladen. Dabei bedeutet VT die Schwellenspannung der Feldeffekttransistoren, die im vorliegenden Fall als gleich angenommen sind. Die Aufladung der Kreuzkopplungsknoten im Ruhezustand sollte auf einen möglichst hohen Spannungswert erfolgen und insbesondere über dem Spannungswert für den höchsten TTL-Eingangssignalpegel liegen. Da der C-Steuerimpuls in der Ruhephase auf etwa 0 V liegt, ist der Transistor 1 nicht leitend. Da ebenfalls der Treiberimpuls DR in der Ruhephase auf 0 V liegt, werden die Ausgänge ST und SC über die leitenden Transistoren 6 und 7 auf Massepotential gehalten. Der in dem einen Ansteuerzweig für den Schaltungsknoten N2 angeordnete Transistor 10, an dessen Gate das TTL-Eingangssignal S liegt, ist in der Ruhephase immer gesperrt, da Drain und Source des Transistors 10 potentialmäßig höher liegen als das Gate. Das Eingangssignal S hat demnach in der Ruhephase keinen Einfluß auf die Schaltung.

Es wird nun angenommen, daß zur Zeit $t_0$ das Eingangssignal (Adreßsignal) S seinen gültigen Wert angenommen hat. Geht daraufhin der Steuerimpuls R zur Zeit $t_1$ $(t_1 - t_0 \geq 0)$ auf Massepotential herunter, werden die Kreuzkopplungsknoten N2 und N3 von der Betriebsspannungsquelle VH abgetrennt und sind demnach potentialmäßig isoliert bzw. "schwimmend". Geht man davon aus, daß das Eingangssignal S im oberen Binärzustand ist, d.h. einen Spannungswert größer oder gleich 2,4 V aufweist, wird beim Abschalten von R auf Massepotential der Feldeffekttransistor 10 leitend. Die Aufgabe des Transistors 10 besteht darin, zwischen den Kreuzkopplungsknoten 2 und 3 ein Differenzsignal $\Delta V$ zu erzeugen, so daß später ein eindeutiges Setzen des Flipflops gewährleistet ist. Vor dem Auftreten des C-Steuerimpulses zum Zeitpunkt $t_2$ ist somit in der noch abgetrennten Verriegelungsschaltung eine vom Eingangssignalzustand abhängige Unsymmetrie durch Absenkung des N2-Potentials erzeugt worden. Mit dem Auftreten des C-Steuerimpulses wird das Flipflop gesetzt. Durch die dann ablaufende Verriegelungswirkung wird der anfänglich kleine $\Delta V$-Wert auf die volle FET-Pegeldifferenz verstärkt. Mit anderen Worten, es wird über die leitenden Transistoren 1 und 2 der Kreuzkopplungsknoten N2 und gleichermaßen auch der Knoten N4 praktisch auf Massepotential entladen. Dadurch wird der Transistor T6 ausgeschaltet. Demgegenüber bleibt das Potential der Knoten N3 und N5 auf dem oberen Wert und der Transistor 7 demzufolge leitend. Geht zum Zeitpunkt $t_3$ der Treiberimpuls DR von Massepotential auf VH über, tritt in der Treiberstufe mit dem Transistor 7 die bekannte Bootstrap-Wirkung auf, und der Ausgang ST nimmt ebenfalls das VH-Potential an. SC bleibt für den hier angenommenen Eingangszustand auf Massepotential.

Ist zu Beginn der Selektion das Eingangssignal S in seinem unteren Binärzustand, d.h. ≤0,6 V, bleibt beim Abschalten von R zum Zeitpunkt $t_1$ der Feldeffekttransistor 10 weiter gesperrt. Somit erfolgt keine Potentialabsenkung am Knoten N2 durch einen Entladestrom über den Transistor 10. Beide Kreuzkopplungsknoten N2 und N3 bleiben in dieser Phase auf dem gleichen Potentialwert, auf den sie zuvor aufgeladen wurden; es wird zu diesem Zeitpunkt noch keine Differenzspannung zwischen N2 und N3 erzeugt. Beim Auftreten des C-Steuerimpulses zum Zeitpunkt $t_2$ wird nun jedoch über C1 gerade soviel Ladung auf den Knoten N2 eingekoppelt, daß dadurch eine Unsymmetrie in der gegenüber dem früher beschriebenen Fall entgegengesetzten Richtung bewirkt wird. Das Potential von N2 wird gegenüber N2 angehoben. Mit dem Setzen des Flipflops wird der Knoten N3 und damit auch der Knoten N5 auf etwa Massepotential entladen. Beim Aktivieren des Treiberimpulses DR erfolgt jetzt in der Treiberstufe mit dem Transistor 6 die genannte Bootstrap-Wirkung, wodurch SC auf VH-Potential geht und ST auf etwa Massepotential bleibt.

Die Feldeffekttransistoren 4 und 5 dienen zur Isolation des jeweils bootstrapenden Schaltungsknotens N4 bzw. N5, da sonst die Kapazität der Knoten N2 bzw. N3 als Parasitärkapazität für den Bootstrap-Vorgang stören würde.

Beendet wird ein derartiger Zyklus zweckmäßig, indem zuerst der C-Steuerimpuls abgeschaltet wird, um zu verhindern, daß über die leitenden Flipflop-Transistoren beim Übergang des R-Steuerimpulses auf VH unnötige Gleichstromverluste auftreten.

Ergänzt man die beschriebene Schaltung entsprechend Fig. 1 in der dort in unterbrochenen Linien gezeigten Weise durch einen Transistor 11 und einen Kondensator C2, bietet die Schaltung zusätzlich die Möglichkeit, daß das TTL-Eingangssignal S bereits vor dem Ende der Selektion seinen Zustand wieder ändern kann. Der Feldeffekttransistor 11 wird an seinem Gate vom R-Impuls gesteuert. Zu der Zeit, in der S seinen gültigen Wert ("Null" oder "Eins") aufweisen muß, ist der Transistor T11 voll leitend und das Eingangssignal wird direkt zum Gate des Transistors 10 und zum Kondensator C2 durchverbunden. C2 dient dabei zur Stabilisierung der Spannung am Gate des Transistors 10, wenn der Transistor 11 ausgeschaltet ist. Wird am Ende der Ruhephase der Steuerimpuls R abgeschaltet, hat das Eingangssignal S infolge des dann gesperrten Transistors 11 keinen Einfluß mehr auf den übrigen Schaltungsteil der Adreßverriegelungsschaltung. Auf der zugehörigen Eingangsleitung für das TTL-Adreßsignal können dann (d.h. für $t > t_1$) bereits wieder Potentialänderungen zugelassen werden, woran in der Regel ein großes Interesse besteht. Ein solcher Eingangssignalwechsel ist in Fig. 2 in unterbrochenen Linien angedeutet.

Wie bereits dargestellt wurde, nutzt die vorliegende Erfindung zur Pegelanpassung und Phasenaufspaltung eines TTL-Eingangssignals bzw. eines damit vergleichbaren Signals die Empfindlichkeit und besondere Verstärkerwirkung eines Verriegelungsschaltkreises aus. Dabei werden über eine besonders ausgeführte Ansteuerung in Abhängigkeit von dem jeweiligen Eingangssignalzustand entgegengesetzt gerichtete Unsymmetrien in dem zunächst noch nicht gesetzten Flipflop erzeugt. Die beiden zu unterscheidenden Eingangszustände bewirken zwischen den Kreuzkopplungsknoten des Verriegelungsschaltkreises Differenzspannungen mit entgegengesetztem Vorzeichen. Bei der nur einseitigen Ansteuerung eines der Kreuzkopplungsknoten wird dessen Potential im einen Fall durch einen verhältnismäßig kleinen Entladestrom abgesenkt und im anderen Fall durch Einkopplung eines kleinen Ladungsbetrages gegenüber dem anderen Kreuzkopplungsknoten angehoben. Die damit im inaktiven bzw. isolierten Zustand des Flipflops vorgenommene Voreinstellung wird anschließend beim Setzen des Flipflops endgültig verriegelt.

Für die schaltungsmäßige Auslegung der Ansteuerung des Kreuzkopplungsknotens, z. B. N2 in Fig. 1, über den Transistor 10 und den Kondensator C1 ist dabei folgendes zu beachten: Es muß gewährleistet sein, daß die über C1 zustandekommende Potentialanhebung beim Auftreten des C-Steuerimpulses kleiner gehalten wird als die evtl. vorher erfolgte Potentialabsenkung über den Feldeffekttransistor 10. Oder mit anderen Worten: Die Auslegung des Ansteuerungszweiges mit 10 und C1 muß gewährleisten, daß im Falle eines Eingangssignales S mit dem oberen Spannungspegel der Entladeeffekt über den Transistor 10 größer ist als die über C1 zustandekommende Potentialanhebung. Ein typischer Wert für die durch Entladung über den Transistor 10 bewirkte Potentialabsenkung beträgt größenordnungsmäßig etwa 0,3 V. Typisch für die durch Potentialanhebung über C1 erzielte Differenzspannung ist etwa ein Wert von 0,15 V. Setzt man demnach für die Potentialabsenkung einen bestimmten Wert ΔV voraus, lassen sich unter Zugrundelegung der am betreffenden Schaltungsknoten, z. B. N2, wirksamen Kapazitätswerte die entsprechenden Werte für den erforderlichen Entladestrom durch den Transistor 10 bzw. dessen Zeitdauer ermitteln. Typische Werte sind größenordnungsmäßig etwa ein Entladestrom von 40 $\mu$A über eine Zeit von z. B. 15 ns. Diese für eine Spannungsabsenkung am Knoten N2 zur Verfügung stehende Entladezeit entspricht im übrigen der Zeitdifferenz $t_2$-$t_1$ in Fig. 2. Aus dem Wert für den zuzulassenden Entladestrom läßt sich dann schließlich bei gegebenen Spannungspegeln für R und S die zugehörige Geometrie (W/L) des Transistors 10 festlegen, z. B. 35/3,5. In gleicher Weise läßt sich bei vorausgesetztem ΔV für die Spannungsanhebung über C1 aus der am Kreuzkopplungsknoten wirksamen (Streu-)Kapazität, den Pegelwerten für den Steuerimpuls C sowie den Flipflop-Parametern der zugehörige Wert für C1 ermitteln. Ein im vorgenannten Zusammenhang typischer Wert liegt größenordnungsmäßig bei etwa 0,075 pF.

Schließlich ist noch darauf hinzuweisen, daß infolge der hohen und gleichmäßigen Aufladung der Kreuzkopplungsknoten N2 und N3 auf nahezu den Betriebsspannungswert VH der beim Setzen des Flipflops eingeschaltete Transistor 2 oder 3 — im Gegensatz zu bekannten Schaltungen dieser Art mit geringerer Voraufladung der Kreuzkopplungsknoten — sofort sehr niederohmig wird und eine schnelle vollständige Entladung des betreffenden Kreuzkopplungsknotens ermöglicht.

Mit der vorliegenden Erfindung ist zusammengefaßt eine sehr schnelle Schaltung zur Umsetzung von TTL-Signalen in solche mit FET-Pegeln möglich, die dazu gleichzeitig in zueinander gegenphasige Signale aufgespalten werden. Die Schaltung bietet eine kleine Eingangskapazität für die TTL-Signale, da mit ihrer Hilfe nur eine relativ kleines Differenzsignal, nicht jedoch ein voller VH-Spannungshub erzeugt werden muß. Der vorgeschlagene Adreßverriegelungsschaltkreis kommt zudem mit einem Minimum an Steuerimpulsen und Hilfsspannungsquellen aus und hat keine Gleichstrom-Verlustleistung.

Günstig für eine Auslegung in integrierter Schaltungstechnik ist ferner der nur geringe Flächenaufwand, da das Eingangssignal nur auf einen Feldeffekttransistor geht und dieser nicht sehr groß zu zein braucht. Ferner läßt sich die Schaltung in einfacher Weise so ergänzen, daß die angelegten Eingangssignale nur relativ kurze Zeit feststehen müssen und sich bereits vor Abschluß der Selektion ihr Potential wieder ändern kann.

**Patentansprüche**

1. Schaltungsanordnung in MOSFET-Technologie zur Phasenaufspaltung und Pegelumsetzung eines TTL-Eingangssignals in FET-Pegel mit einem taktgesteuerten Flipflop (1, 2, 3), dessen Kreuzkopplungsknoten (N2, N3) mit zugehörigen Ausgangstreiberstufen über Isolationselemente (4, 5) und mit Schaltungsmitteln (8, 9) zur in der Ruhephase erfolgenden Aufladung der Kreuzkopplungsknoten aus der Betriebsspannungsquelle verbunden sind, gekennzeichnet durch die folgenden Merkmale: nur mit einem der Kreuzkopplungsknoten (N2) ist eine Ansteuerschaltung gekoppelt, die in bekannter Weise einen ersten Schaltungszweig (S, R, 10) für eine in Abhängigkeit vom jeweiligen Eingangssignal (S) erfolgende Potentialabsenkung sowie einen zweiten Schaltungszweig (C, C1) für eine anschließende und unabhängig vom Eingangssignal vorzunehmende Potentialanhebung des betreffenden Kreuzkopplungsknoten enthält; die beiden Schaltungszweige sind so ausgelegt, daß die über den zweiten Schaltungs

zweig, dessen Eingang in bekannter Weise mit dem Steuertakt- bzw. Setzeingang des Flipflops gekoppelt ist, zustandekommende Potential-anhebung des betreffenden Kreuzkopplungs-knoten kleiner als eine über den ersten Schaltungszweig zustandekommende Potentialabsenkung ist.

2. Schaltungsanordnung nach Anspruch 1, dadurch gekennzeichnet, daß der erste Schaltungszweig einen mit seiner Drain-Source-Strecke zwischen dem einen Kreuzkopplungsknoten (N2) und einem Steuerimpulseingang (R) angeordneten Feldeffekttransistor (10) enthält, dessen Gate mit dem Eingang für das TTL-Eingangssignal (S) verbunden ist, und daß der zweite Schaltungszweig in an sich bekannter Weise ein kapazitives Bauelement (C1) zur Einkopplung eines definierten Ladungsbetrages auf den Kreuzkopplungsknoten (N2) beim Auftreten des das taktgesteuerte Flipflop (1, 2, 3) setzenden Steuersignals (C) enthält.

3. Schaltungsanordnung nach Anspruch 2, dadurch gekennzeichnet, daß das TTL-Eingangssignal (S) über einen in der Ruhephase leitenden Feldeffekttransistor (11) auf das Gate des im ersten Schaltungszweig enthaltenen Feldeffekttransistor (10) gekoppelt wird.

4. Schaltungsanordnung nach Anspruch 3, gekennzeichnet durch ein mit dem Gate des im ersten Schaltungszweig enthaltenen Feldeffekt-transistors (10) verbundenes kapazitives Bau-element (C2) zur Stabilisierung des dort ge-speicherten Eingangssignalzustandes nach Ab-schluß der Ruhephase.

5. Verfahren zur Erzeugung phasenaufgespaltener und in FET-Pegel umgesetzter Signale aus einem TTL-Eingangssignal unter Aus-nutzung der Verriegelungswirkung eines taktge-steuerten Flipflops, dadurch gekennzeichnet, daß in ein in an sich bekannter Weise während der Ruhephase potentialmäßig symmetrisch aus der Betriebsspannungsquelle (VH) aufgeladenes Flipflop einseitig eine elektrische Unsymmetrie eingeführt wird, die aus einer in Abhängigkeit vom Eingangssignalzustand zustandekommenden Potentialabsenkung und einer in jedem Fall im Anschlüß daran vorgenommenen konstanten Potentialanhebung mit gegenüber der etwaig vorhergegangenen Potentialabsenkung geringerem Ausmaß herbeigeführt wird, und daß die daraus resultie-rende und vom Eingangssignalzustand abhän-gige elektrische Unsymmetrie anschließend in an sich bekannter Weise durch das Setzen des Flipflops und die dadurch einsetzende Verriegelungswirkung verstärkt wird.

## Revendications

1. Circuit réalisé dans la technologie MOSFET pour la séparation de phases et pour le changement de niveau d'un signal d'entrée TTL en niveaux FET, comportant une bascule conditionnée (1, 2, 3) dont let noeuds en montage croisé (N2, N3) sont connectés, à travers des éléments d'isolement (4, 5), aux étages de commande de sortie associés et aux moyens de commutation (8, 9) pour charger, en phase de repos, les noeuds en montage croisé à partie de la source de tension de fonctionnement, caractérisé par les caractéristiques suivantes:

un seul des noeuds en montage croisé (N2) est couplé à un circuit de commande comportant, de façon connue, une première branche de circuit (S, R, 10) pour l'abaissement du potentiel en fonction du signal d'entrée respectif (S), et une seconde branche de circuit (C, C1) pour élever ensuite le potentiel de noeud respectif indépendamment du signal d'entrée;

les deux branches de circuit sont conçues de telle manière que l'élévation du potentiel du noeud respectif obtenu à travers la seconde branche de circuit dont l'entrée est couplée, de façon connue, à l'entrée de conditionnement ou d'enclenchement de la bascule, est inférieure à l'abaissement du potentiel obtenu à travers la première branche de circuit.

2. Circuit selon la revendication 1, caractérisé en ce que la première branche de circuit comporte un transistor à effet de champ (10) dont la région drain-source est située entre le noeud à montage croisé (N2) et une entrée d'impulsion de commande (R), la porte du transistor à effet de champ étant connectée à l'entrée du signal d'entrée TTL (S), et en ce que la seconde branche de circuit comporte, de façon connue, un élément capacitif (C1) pour appliquer une charge définie sur le noeud à montage croisé (N2) lorsque le signal de commande (C) enclenchant la bascule conditionnée (1, 2, 3) apparaît.

3. Circuit selon la revendication 2, caractérisé en ce que le signal d'entrée TTL (S) est appliqué, à travers un transistor à effet de champ (11), conducteur en phase de repos, à la porte du transistor à effet de champ (10) contenu dans la première branche de circuit.

4. Circuit selon la revendication 3, caractérisé par un élément capacitif (C2) connecté à une porte du premier transistor à effet de champ (10) contenu dans la première branche de circuit pour stabiliser l'état de signal d'entrée qui y est emmagasiné après la phase de repos.

5. Procédé pour générer des signaux à phases séparées et convertis en un niveau FET à partir d'un signal d'entrée TTL en utilisant l'effet de verrouillage d'une bascule conditionnée, caractérisé en ce qu'on introduit unilatéralement une dissymétrie électrique dans une bascule, dont le potentiel est, de façon connue, chargé symétriquement durant la phase de repos, et ce, à partir d'une source de tension de service (VH), ladite dissymétrie étant due à un abaissement de potentiel obtenu en fonction de l'état du signal d'entrée, et à une élevation de potentiel constante obtenue ensuite dans tous les cas, mais étant moins importante que l'abaissement du potentiel précédant éventuellement, et en ce que, ensuite, la dissymétrie électrique qui en résulte et qui est une fonction de l'état du signal d'entrée est amplifiée, de façon connue, par l'enclenchement de la bascule et par l'effet de verrouillage ainsi provoqué.

**Claims**

1. Circuit arrangement in MOSFET technology for phase splitting and level conversion of a TTL-input signal into FET levels with a gated flipflop (1, 2, 3) whose latch nodes (N2, N3) are connected to associated output drive stages via insulation elements (4, 5) and to circuit means (8, 9) for the charging in the standby phase of the latch nodes from the operating voltage source, characterized by the following features:

— only to one latch node (N2) a control circuit is coupled which comprises in a known manner a first circuit branch (S, R, 10) causing a potential decrease taking place as a function of the respective input signal (S), as well as a second circuit branch (C, C1) causing a potential increase taking place subsequently and independently of the input signal, of the respective latch node;

— the two circuit branches are designed in such a manner that the potential increase of the respective latch node taking place via the second circuit branch whose input is coupled in a known manner to the input for the gating or set pulse of the flipflop, is smaller than a potential decrease effected via the first circuit branch.

2. Circuit arrangement as claimed in claim 1, characterized in that the first circuit branch contains a field effect transistor (10) arranged with its drain-source path between the one latch node (N2) and a control pulse input (R), the gate of the field effect transistor being connected to the input for the TTL-input signal (S), and the the second circuit branch contains in a manner known per se a capacitive component (C1) for coupling-in a defined charge to the latch node (N2) upon the appearance of the control signal (C) setting the gated flipflop (1, 2, 3).

3. Circuit arrangement as claimed in claim 2, characterized in that the TTL-input signal (S) is coupled via a field effect transistor (11) which is conducting in the standby phase, to the gate of the field effect transistor (10) in the first circuit branch.

4. Circuit arrangement as claimed in claim 3, characterized by a capacitive component (C2) connected to the gate of the field effect transistor (10) in the first circuit branch for stabilizing the input signal state stored there after the termination of the standby phase.

5. Method of generating phase-split signals being converted in FET levels, of a TTL-input signal utilizing the latching action of a gated flipflop, characterized in that into a flipflop precharged in a manner known per se symmetrically during the standby phase from the operating voltage source (VH) an electric asymmetry is introduced on one side which is produced from a potential decrease caused as a function of the input signal state, and an unconditional constant potential increase executed subsequently to a smaller extent than the conditional preceding potential decrease, and that the electric asymmetry resulting therefrom and depending on the input signal state is subsequently amplified in a manner known per se through the setting of the flipflop and the latching action caused thereby.

# FIG. 1

# FIG. 2